# EUROPEAN PATENT APPLICATION

(11) **EP 4 414 724 A1**
(43) Date of publication of application: **14.08.2024**
(21) Application number: 23220794.4
(22) Date of filing: 29.12.2023
(51) Int. Cl.: G01R 31/303, G01R 31/311

(54) **FAULT ISOLATION VIA ELECTRON PHOTOEMISSION MICROSCOPY**

(30) Priority: 13.02.2023 US 202318167964
(71) Applicant: INTEL Corporation, Santa Clara, CA 95054 (US)
(72) Inventor: KEVEK, Joshua, Portland, Oregon 97203 (US); SENGER, Mitchell, Portland, Oregon 97209 (US)
(74) Representative: HGF

(57) **Abstract**

This disclosure describes systems, methods, and devices related to fault isolation via electron photoemission microscopy (FIVEPM). A system may attach a device under test (DUT) comprising a region of interest (ROI) for fault isolation to a tester device, wherein the DUT is an integrated circuit. The system may pulse an ultraviolet UV beam targeting the ROI on the DUT using a UV laser. The system may capture, using a detector, excited electrons as signals based on the UV beam targeting the ROI. The system may synchronize a time domain electrical signal analyzer to a reference frequency. The system may generate a rastered image associated with the fault isolation.

## Description

### TECHNICAL FIELD

This disclosure generally relates to systems and methods for fault isolation and, more particularly, to fault isolation via electron photoemission microscopy (FIVEPM).

### BACKGROUND

The introduction of enhanced power devices sandwiched on either side of a transistor layer with layers of power delivery and signal-carrying metals introduced a problem for using fault isolation and failure analysis (FIFA) tools and processes which previously relied on backside probing of the transistors using optical or near-infrared light. With these enhanced power devices, FIFA processes are obfuscated by metal.

### BRIEF DESCRIPTION OF THE DRAWINGS

FIGs. 1-2 depict illustrative schematic diagrams for fault isolation via electron photoemission microscopy (FIVEPM), in accordance with one or more example embodiments of the present disclosure.
FIG. 3 illustrates a flow diagram of a process for an illustrative FIVEPM system, in accordance with one or more example embodiments of the present disclosure.

### DETAILED DESCRIPTION

The following description and the drawings sufficiently illustrate specific embodiments to enable those skilled in the art to practice them. Other embodiments may incorporate structural, logical, electrical, process, algorithm, and other changes. Portions and features of some embodiments may be included in, or substituted for, those of other embodiments. Embodiments set forth in the claims encompass all available equivalents of those claims.

Several FIFA techniques have been devised since the introduction of enhanced power devices to tackle this issue. These can be sorted into three categories: 1) precisely removing metal in the stack up to expose the transistor layer (so-called 3DFI prep), 2) probing through the obfuscating metal lines to the transistor layer, and 3) probing the metal signal lines themselves.

The first technique (removing the metal) is accomplished namely through developments in prep technology. The redundant power delivery semiconductor package is first drilled with a high-precision milling bit, then wet-etched to remove large features, and finally, milled using a P-FIB to expose a ~100 um² of FinFETs / GAAFETs behind the back-metal. FIFA tools can then access the transistor layer using some traditional optical or scanning electron microscope (SEM) based probe techniques.

For the second technique, seeing through the metal stack is made possible either by signaling with photons with wavelengths that allow them to transmit through the metal stack (*λ* > 2000 *µm* or *λ* ~ 1 *nm*)*,* or engineering channels wide enough for optical photons to transmit to and from the transistor layer. Both have been demonstrated to some success.

The third technique (probing signal lines in the metal stack) has traditionally been accomplished with direct pad probing for large features or nanoprobing for smaller features. Recently, electron-beam probing (EBP), where a lock-in amplifier is used to pick out modulations in the number of captured secondary electrons induced by a signal line's voltage swing has also demonstrated signal map imaging on metal in a flip-chip stack. A lock-in amplifier is an amplifier that can extract a signal with a known carrier wave from a noisy environment.

There are disadvantages to using some of these techniques. For example, 3DFI prep tends to induce electrical failures in the exposed area. Shorts are commonly induced by adherence to milled material and can bridge power delivery lines. Milling the interlayer dielectric above the transistors is a very manual process and is prone to overshooting the endpoint, thereby recessing the transistors themselves. Techniques using very long or very short photons to probe transistors through a metal stack suffer from diminished resolution. Tools utilizing thermal photons are generally limited by the Rayleigh Criterion to a resolution ≳ 400 nm which is a significant downgrade from the ~100 nm resolution attainable to visible photon-based tools. X-Rays tools suffer from the technological difficulty of focusing an X-Ray beam. So far, lab-scale X-Ray tools with flux densities suitable for inducing/detecting signals from FinFETs have spot sizes ≥ 2000 nm. Pad probing relies on large metallic lands being placed on the unit, occupying valuable real estate on the die. Nanoprobing is the most direct and precise FI technique, but its throughput time (TPT) scales with the area of the ROI. Traditionally, optical FI techniques are used to narrow the ROI for nanoprobing to bring the overall TPT of a to debug job to an acceptable level. Detectors in EBP schemes rely on a scintillator/photomultiplier tube combination, which is generally limited to low-MHz bandwidth (BW), to detect secondary electrons (SEs) that carry the device under test (DUT) signal. Measurements up to about 1 GHz have been demonstrated using stroboscopic techniques. Although EBP may provide good resolution, material may need to be physically removed from the semiconductor package of enhanced power devices to expose the signals of interest. Additionally, the bandwidth of the detector in electron-beam probing may be limited to about 5 MHz. SEM vendors have accomplished this by pulsing a SEM's electron beam with a high-speed beam-blanker to strobe the desired signal within the bandwidth (BW) of the detector's photomultiplier tube (PMT), and using the strobed signal to back-determine the lock-in frequency. While this is an effective means of high-BW signal capture for metal lines, high-speed beam-blanking is still in its infancy. The tools that support this are very expensive, and the market for them is not expected to expand dramatically in the short term.

Example embodiments of the present disclosure relate to systems, methods, and devices for fault isolation via electron photoemission microscopy (FIVEPM).

In one or more embodiments, a FIVEPM system may capture the signal from a device where the transistor layer is fully covered by metal. A FIVEPM system may provide end-of-line feedback using fault isolation and failure analysis of an integrated circuit (e.g., wafer/semiconductor package). This end-of-line feedback may enhance the fabrication process by pinpointing failures. The FIVEPM system may facilitate analyzing signals on a metal layer that is covering the front side of the integrated circuit and blocking the transistor layer.

In one embodiment, a FIVEPM system may use photoexcited electrons, generated by a pulsed UV laser, to stroboscopically detect a ~1 GHz signal from metal lines on an enhanced power device. An enhanced power device may comprise power wires that are placed underneath a transistor layer, on the backside of a wafer. Power is delivered directly from the package to the transistors through metal layers that are optimized for power delivery. Likewise, a signal layer placed on top of the transistor layer may create more space for signal trace separation, shorter traces, fewer bends/corners, and the use of more dielectric material, which together serve to optimize signal routing to reduce signal interference, power losses, and coupling effects.

In one or more embodiments, the stroboscopic detection scheme of a FIVEPM system may drastically improve the signal from a photoemission electron microscope (PEEM) and enable fault isolation and design debugging for next-generation process technologies. UV wavelengths permit higher resolution for signal capture than tools leveraging infrared (IR), visible, or x-ray radiation. Stroboscopically capturing a signal via a pulsed laser offers higher BW detection than POR optical FI tools and strobing a UV laser is easily accomplished with chopper wheels, PED devices, or electro-optic modulators, all of which are long-standing technologies.

In one or more embodiments, the basis of PEEMs, namely the laser, beam routing hardware, chopper, vacuum system, and electron detector can be incorporated into a fault isolation (FI) tool design, and therefore tools could be designed to accommodate numerous test board designs.

The above descriptions are for purposes of illustration and are not meant to be limiting. Numerous other examples, configurations, processes, algorithms, etc., may exist, some of which are described in greater detail below. Example embodiments will now be described with reference to the accompanying figures.

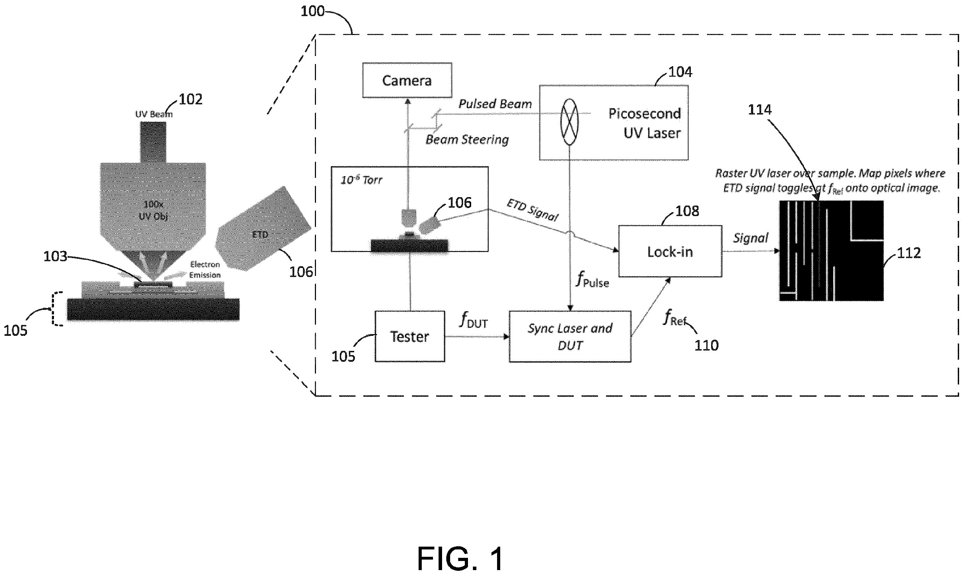

FIGs. 1-2 depicts illustrative schematic diagrams for FIVEPM, in accordance with one or more example embodiments of the present disclosure.

Referring to FIG. 1, there is shown a schematic for a FIVEPM system 100. The schematic shows a proposed PEEM that could mount an active DUT 103 on a tester 105 and capture signals (e.g., ETD signals) from the active DUT 103.

In one or more embodiments, FIFA feedback for device fabrication relies on gathering signals from defective units that indicate the location of a defect. Previous optical-based techniques for fault isolation, such as lock-in thermography, optical beam-induced resistance change, laser voltage imaging, and laser-assisted device alteration all examine either modulations in the light reflected from the sample or modulations in the device behavior induced by incident light. Fault isolation was traditionally accomplished by illuminating the transistor layer in a device. Engineers could map locations on active devices where light is emitted more intensely to mark locations that are experiencing a defect (e.g., shorted locations), where transistors are toggling and compare to layout to mark opens, or, identify spots that when illuminated with a laser switch the device from passing a test pattern to failing. Landing or measuring light from a device's transistor layer is much more difficult with the introduction of enhanced power devices, where the transistors are sandwiched between two layers of metal.

In one or more embodiments, a FIVEPM system may bypass direct transistor imaging by mapping a device's toggling metal features using a novel PEEM. Instead of using a pulsed SEM to create a secondary electron signal, a FIVEPM system may pulse a UV laser at a sample of an ROI, where the metal line may be experiencing a defect (e.g., toggling metal line due to an electrical short or other defects). A UV laser will photo-excite secondary electrons (SEs) and affect them similarly to a SEM. Higher bandwidth may be achieved by using stroboscopic techniques using a pulse laser system that has a more mature and reliable technology. UV provides a better resolution than other optical technologies or X-Rays. For example, the resolution limit could be down below 200 nm or 150 nm, which is sufficient for working with signal metals to be probed that may be larger than 150 nm or so. As long as the resolution of the microscope is below or closer to the feature for measuring signals, individual signals could be resolved from individual metal lines. In FIG. 1, it is shown that the UV laser has an objective of 100x, however, a FIVEPM system may be used with other objectives smaller or larger than 100x. For example, in the case of package debug, where resolutions may need to be lower. At lower wavelengths, the SEs count that is generated at the ETD may be higher, therefore, the signal-to-noise ratio (SNR) does not need to be aggressive at the ETD in order to perform the defect detection at the lock-in amplifier.

In one or more embodiments, with photoemitting electrons, when a change in the voltage occurs on a metal line, the kinetic energy of the emitted secondary electrons changes as well. For secondary electrons emitted in a photoemission process, it is expected that the change may be about 5 electron volts (eV), which is roughly the same energy as the UV photons put in the system. Thus, if the metal line is toggled at 1 volt or 0.5 volts, the kinetic energy of the secondary electrons may change by 1-10%. It should be understood that these values are for illustration purposes and not intended to be limiting and that other values may be used.

In one or more embodiments, a FIVEPM system may facilitate that PEEMs may leverage the photoelectric effect to image samples. Typically, UV laser light is focused on a sample. If the sample is metallic, it emits electrons with kinetic energy *Eₑ* = *hv* - *W,* where *hv* is the photon energy of the UV light, and *W* is the metal's work function. *Eₑ* is on the order of 5 eV depending on the laser source. The emitted electrons are detected with an energy-resolved Everhart-Thornley detector (ETD) which is used to image the sample.

In one or more embodiments, a FIVEPM system may facilitate that active metal lines on a DUT, which are driven by an electrical tester, modulate the kinetic energy of emitted electrons. If the UV laser is landed on a metal line carrying a voltage signal *V*(*t*)*,* the emitted electrons' kinetic energy will change temporally with *Eₑ*(*t*) = *hv* - *W* - *eV*(*t*)*,* where e is the elementary charge. For a 0.5 V p-p signal, the kinetic energy of the emitted electrons will swing by 1-10%.

Referring to FIG. 1, a defective unit with prep-exposed signal metal (e.g., a DUT) is loaded onto a test interface unit (TIU) inside an optical vacuum chamber. The TIU is the interface between the DUT, the tester, and the handler. It is composed of a test socket or contactor that holds the DUT on the DUT board. The DUT board mounts onto the test head via a mechanical frame/fixture.

In one or more embodiments, a signal may be traced along the path that has been identified to contain a defect. An engineer may facilitate the exposure of the metal carrying that signal on the signal line. The metal may be then probed with the photoemission electron microscope.

In one or more embodiments, a UV beam 102 from a UV laser 104 (e.g., a picosecond UV laser or other equivalent laser types) is routed through kinetic beam optics (steering optics) into the vacuum chamber and landed on the DUT 103. In other words, the UV laser 104 is a source that generates pulses that are about 100 picoseconds wide that are routed through steering optics. Light (e.g., UV beam 102) that is targeted on the exposed DUT metal excites electrons that are emitted from the sample in the ROI and captured by an ETD 106. The ETD signal is fed to a lock-in amplifier 108 that is synced to the laser strobe frequency and the DUT via the tester 105. The tester 105 feeds in an electrical pattern into the DUT 103 at the ROI where a failure is expected (e.g., signal to toggle due to a short or defect). The tester 105 may be running a signal-in at a certain frequency (e.g., a 1 MHz frequency or other frequency). What is being fed from the tester 105 to the lock-in amplifier 108 is a reference signal 110 indicating to the lock-in amplifier 108 that the signal of interest is for that certain frequency (e.g., 1 MHz or other frequency).

In one or more embodiments, in case the signal being measured by the tester 105 is faster than the ETD 106 and in order to capture the faster signal in the bandwidth of the ETD 106, the UV beam 102 may be pulsed at a frequency (fₚᵤₗₛₑ) that is close to the tester frequency (f_{TUD}). For example, if the UV beam 102 and the DUT signal from the tester 105 is pulsed at a specific frequency (f_{Ref}), the pulsed beam may land on the signal line that is experiencing the defect (e.g., toggling) and the ETD 106 may read the signal at that frequency. For that reason, the pulse from the laser and the DUT signals need to be synced. In order to do that crystal oscillators may be used such that the pulse from the laser and the DUT signal may trigger each other. That is, the tester frequency out may be used to trigger the pulses in the UV laser or vice versa. This way the lock-in amplifier 108 would know which time basis it should be using such that the signal coming out of the lock-in amplifier is relevant.

In one or more embodiments, the UV beam may be rastered over the sample, and the output of the lock-in amplifier 108 may be plotted over an optical micrograph of the ROI revealing the features that are experiencing a defect 114 (e.g., toggling due to a short or other types of the defect) at the reference frequency (f_{Ref})110. The ETD 106 may read secondary electron (SE) counts continuously and when there is a change (e.g., a 1 MHz change or other change) on the SE count coming out as an ETD signal, that ETD signal can be identified by the lock-in amplifier 108. Then, if the beam is rastered through the sample, an image output 112 will show where the lock-in amplifier 108 is high or low and map out where the defect 114 is happening (e.g., toggling signal).

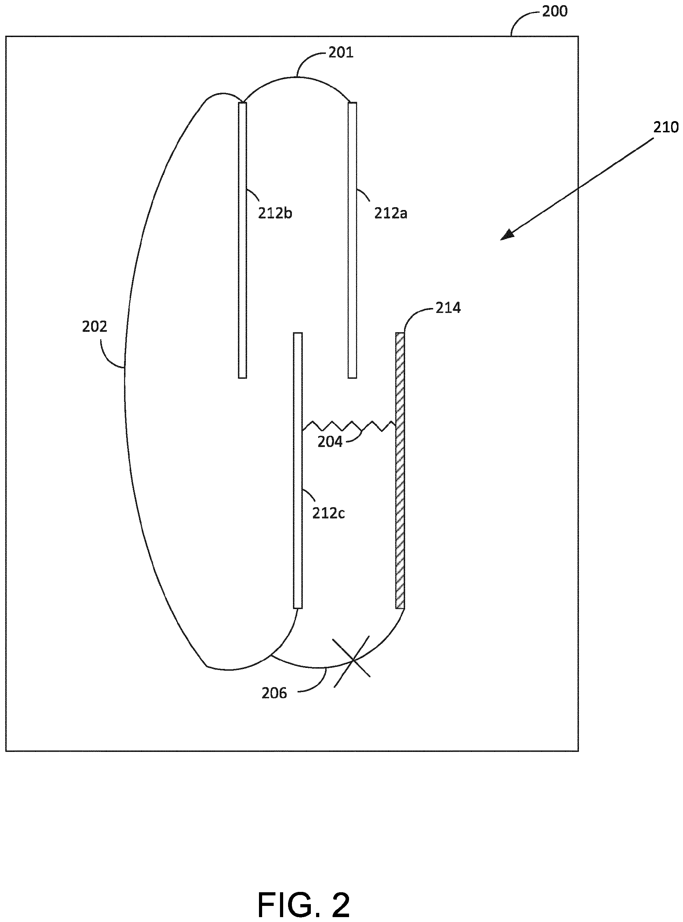

Referring to FIG. 2, the region 210 comprises dielectric, the regions 212a-c comprise metal lines, and the region 214 is a metal line that is experiencing a defect (e.g., toggling due to a short 204 or other defects). In normal operation, line 212a may be connected to line 212b through connection 201, line 212b may be connected to line 212c through connection 202. Due to the defect, line 214 may erroneously connect to line 212c and form connection 206 due to the short 204.

In one or more embodiments, a FIVEPM system may use a time domain electrical signal analyzer (e.g., the lock-in amplifier 108 of FIG. 1 or a spectrum analyzer) due to its capability to easily isolate the components of a signal that are experiencing a defect (e.g., toggling due to a short or other defects) at the same frequency as an expected signal to ppm level.

In one or more embodiments, a FIVEPM system may facilitate that the ETD signal is fed to a lock-in amplifier that is referenced to the signal the tester is supplying to the DUT. The FIVEPM system may determine what metal features are toggling at the reference frequency in an ROI by rastering the UV laser over the sample and collecting the lock-in signal at each point in the raster. Graphics processing software can then map the lock-in amplifier output signal over an optical micrograph of the sample, displaying which features produced the toggling signal.

In some embodiments, a FIVEPM scheme may be incompatible with solid immersion lenses (SILs). SILs were developed to enhance the resolution performance of traditional optical tools that use visible or infrared light. If a SIL were used in a FIVEPM tool, there would be no easy path to collect emitted electrons. These tools will need to leverage "air" lenses with long working distances to focus the laser on samples. While the resolution of these tools cannot be improved with immersion, they operate with shorter wavelengths (*λ*) than traditional tools. The shortest resolvable distance (*l*) for an optical system is given by *l* = *λ*/2*NA,* where *NA* is the numerical aperture of the lens. Typical UV lasers have wavelengths near 200 nm, so *l* ≈ 150 nm for a system with a 100x air lens with *NA* = 0.8. This is short enough to resolve most single metal lines on enhanced power devices. In one or more embodiments, a FIVEPM system offers a pathway to fast, contactless, signal probing of metal lines with high resolution and high signal-to-noise response. It is understood that the above descriptions are for purposes of illustration and are not meant to be limiting.

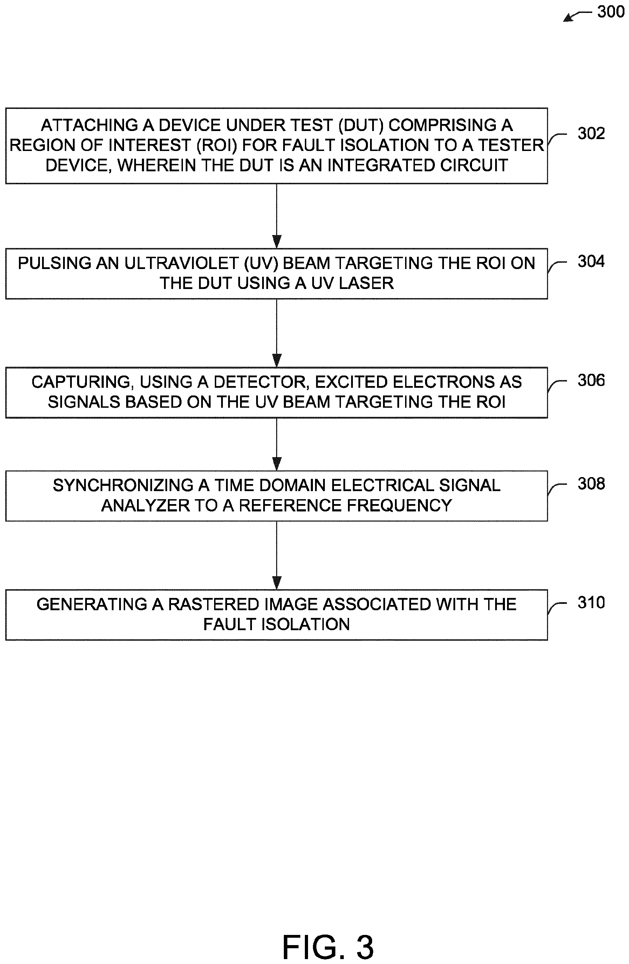

FIG. 3 illustrates a flow diagram of a process 300 for a FIVEPM system, in accordance with one or more example embodiments of the present disclosure.

In some embodiments, the FIVEPM system may be configured to perform one or more processes, techniques, or methods as described herein, or portions thereof. One such process is depicted in FIG. 3.

For example, the process may include, at 302, attaching a device under test (DUT) comprising a region of interest (ROI) for fault isolation to a tester device, wherein the DUT is an integrated circuit. The integrated circuit may comprise a transistor layer that is enclosed between a first metal layer and a second metal layer. The tester device may send signals through the integrated circuit.

The process further includes, at 304, pulsing an ultraviolet UV beam targeting the ROI on the DUT using a UV laser. The UV laser may be a pulsed picosecond UV laser. The UV beam may pass through an electron photoemitting microscope having a predetermined UV objective lens.

The process further includes, at 306, capturing, using a detector, excited electrons as signals based on the UV beam targeting the ROI.

The process further includes, at 308, synchronizing a time domain electrical signal analyzer (e.g., a lock-in amplifier or a spectrum analyzer) to a reference frequency. The pixels may be associated with a metal signal line that toggles at the reference frequency. The reference frequency may be based on a tester frequency, a DUT frequency, or a pulsed UV beam frequency.

The process further includes, at 310, generating a rastered image associated with the fault isolation. The rastered image may be compared to a reference image of a similar region of the integrated circuit. The rastered image may be generated by mapping pixels associated with the signals onto an optical image.

It is understood that the above descriptions are for purposes of illustration and are not meant to be limiting.

The word "exemplary" is used herein to mean "serving as an example, instance, or illustration." As used herein, unless otherwise specified, the use of the ordinal adjectives "first," "second," "third," etc., to describe a common object, merely indicates that different instances of like objects are being referred to and are not intended to imply that the objects so described must be in a given sequence, either temporally, spatially, in ranking, or in any other manner.

Some embodiments may be used in conjunction with various devices and systems, for example, a personal computer (PC), a desktop computer, a mobile computer, a laptop computer, a notebook computer, a tablet computer, a server computer, a handheld computer, a handheld device, a personal digital assistant (PDA) device, a handheld PDA device, an on-board device, an off-board device, a hybrid device, a vehicular device, a non-vehicular device, a mobile or portable device, a consumer device, a non-mobile or non-portable device, a wireless communication station, a wireless communication device, a wireless access point (AP), a wired or wireless router, a wired or wireless modem, a video device, an audio device, an audio-video (A/V) device, a wired or wireless network, a wireless area network, a wireless video area network (WVAN), a local area network (LAN), a wireless LAN (WLAN), a personal area network (PAN), a wireless PAN (WPAN), and the like.

A system of one or more computers can be configured to perform particular operations or actions by virtue of having software, firmware, hardware, or a combination of them installed on the system that in operation causes or cause the system to perform the actions. One or more computer programs can be configured to perform particular operations or actions by virtue of including instructions that, when executed by data processing apparatus, cause the apparatus to perform the actions. One general aspect includes a system. The system includes a tester device interfacing the DUT. The system also includes an ultraviolet (UV) laser configured to pulse a UV beam targeting the ROI on the DUT. The system also includes a detector (e.g., an everhart-thornley detector (ETD)) configured to capture excited electrons as signals (e.g., ETD signals) based on the UV beam targeting the ROI. The system also includes a time-domain electrical signal analyzer (e.g., a lock-in amplifier or a spectrum analyzer) synchronized to a reference frequency, where the time-domain electrical signal analyzer causes a generation of a rastered image associated with the fault isolation. Other embodiments of this aspect include corresponding computer systems, apparatus, and computer programs recorded on one or more computer storage devices, each configured to perform the actions of the methods.

Implementations may include one or more of the following features. The system where the UV laser is a picosecond UV laser. The integrated circuit may include a transistor layer that is enclosed between a first metal layer and a second metal layer. The tester device sends signals through the both metal layers and the transistor layer of the DUT. The rastered image is compared to a reference image of a similar region of the integrated circuit. The UV beam passes through an electron photoemitting microscope having a predetermined uv objective lens. The rastered image is generated by mapping pixels associated with the signals onto an optical image. The pixels are associated with a metal signal line that toggles at the reference frequency. The reference frequency is either a tester frequency or a pulsed UV beam frequency. Implementations of the described techniques may include hardware, a method or process, or computer software on a computer-accessible medium.

One general aspect includes a method. The method also includes attaching a device under test (DUT) may include a region of interest (ROI) for fault isolation to a tester device, where the DUT is an integrated circuit. The method also includes pulsing an ultraviolet UV beam targeting the ROI on the DUT using a UV laser. The method also includes capturing, using a detector (e.g., an everhart-thornley detector (ETD)), excited electrons as signals (e.g., ETD signals) based on the UV beam targeting the ROI. The method also includes synchronizing a time-domain electrical signal analyzer (e.g., a lock-in amplifier or a spectrum analyzer) to a reference frequency. The method also includes generating a rastered image associated with the fault isolation. Other embodiments of this aspect include corresponding computer systems, apparatus, and computer programs recorded on one or more computer storage devices, each configured to perform the actions of the methods.

Implementations may include one or more of the following features. The method where the UV laser is a picosecond UV laser. The integrated circuit may include a transistor layer that is enclosed between a first metal layer and a second metal layer. The tester device sends signals through the first metal layer of the DUT. The rastered image is compared to a reference image of a similar region of the integrated circuit. The UV beam passes through an electron photoemitting microscope having a predetermined UV objective lens. The rastered image is generated by mapping pixels associated with the signals onto an optical image. The pixels are associated with a metal signal line that toggles at the reference frequency. The reference frequency is either a tester frequency or a pulsed UV beam frequency. Implementations of the described techniques may include hardware, a method or process, or computer software on a computer-accessible medium.

One general aspect includes an apparatus. The apparatus includes a device under test (dut) may include a region of interest (roi) for fault isolation, where the dut is an integrated circuit. The apparatus also includes a tester device for fault isolation on a region of interest (roi). The apparatus also includes an ultraviolet (uv) laser configured to pulse a uv beam targeting the roi. The apparatus also includes a detector configured to capture excited electrons as signals based on the uv beam targeting the roi. The apparatus also includes a time-domain electrical signal analyzer synchronized to a reference frequency, where the time-domain electrical signal analyzer causes a generation of a rastered image associated with the fault isolation. Other embodiments of this aspect include corresponding computer systems, apparatus, and computer programs recorded on one or more computer storage devices, each configured to perform the actions of the methods.

Implementations may include one or more of the following features. The apparatus where the UV laser is a picosecond UV laser. The integrated circuit may include a transistor layer that is enclosed between a first metal layer and a second metal layer. Implementations of the described techniques may include hardware, a method or process, or computer software on a computer-accessible medium.

Embodiments according to the disclosure are in particular disclosed in the attached claims directed to a method, a storage medium, a device and a computer program product, wherein any feature mentioned in one claim category, e.g., method, can be claimed in another claim category, e.g., system, as well. The dependencies or references back in the attached claims are chosen for formal reasons only. However, any subject matter resulting from a deliberate reference back to any previous claims (in particular multiple dependencies) can be claimed as well, so that any combination of claims and the features thereof are disclosed and can be claimed regardless of the dependencies chosen in the attached claims. The subject-matter which can be claimed comprises not only the combinations of features as set out in the attached claims but also any other combination of features in the claims, wherein each feature mentioned in the claims can be combined with any other feature or combination of other features in the claims. Furthermore, any of the embodiments and features described or depicted herein can be claimed in a separate claim and/or in any combination with any embodiment or feature described or depicted herein or with any of the features of the attached claims.

The foregoing description of one or more implementations provides illustration and description, but is not intended to be exhaustive or to limit the scope of embodiments to the precise form disclosed. Modifications and variations are possible in light of the above teachings or may be acquired from practice of various embodiments.

Certain aspects of the disclosure are described above with reference to block and flow diagrams of systems, methods, apparatuses, and/or computer program products according to various implementations. It will be understood that one or more blocks of the block diagrams and flow diagrams, and combinations of blocks in the block diagrams and the flow diagrams, respectively, may be implemented by computer-executable program instructions. Likewise, some blocks of the block diagrams and flow diagrams may not necessarily need to be performed in the order presented, or may not necessarily need to be performed at all, according to some implementations.

These computer-executable program instructions may be loaded onto a special-purpose computer or other particular machine, a processor, or other programmable data processing apparatus to produce a particular machine, such that the instructions that execute on the computer, processor, or other programmable data processing apparatus create means for implementing one or more functions specified in the flow diagram block or blocks. These computer program instructions may also be stored in a computer-readable storage media or memory that may direct a computer or other programmable data processing apparatus to function in a particular manner, such that the instructions stored in the computer-readable storage media produce an article of manufacture including instruction means that implement one or more functions specified in the flow diagram block or blocks. As an example, certain implementations may provide for a computer program product, comprising a computer-readable storage medium having a computer-readable program code or program instructions implemented therein, said computer-readable program code adapted to be executed to implement one or more functions specified in the flow diagram block or blocks. The computer program instructions may also be loaded onto a computer or other programmable data processing apparatus to cause a series of operational elements or steps to be performed on the computer or other programmable apparatus to produce a computer-implemented process such that the instructions that execute on the computer or other programmable apparatus provide elements or steps for implementing the functions specified in the flow diagram block or blocks.

Accordingly, blocks of the block diagrams and flow diagrams support combinations of means for performing the specified functions, combinations of elements or steps for performing the specified functions and program instruction means for performing the specified functions. It will also be understood that each block of the block diagrams and flow diagrams, and combinations of blocks in the block diagrams and flow diagrams, may be implemented by special-purpose, hardware-based computer systems that perform the specified functions, elements or steps, or combinations of special-purpose hardware and computer instructions.

Conditional language, such as, among others, "can," "could," "might," or "may," unless specifically stated otherwise, or otherwise understood within the context as used, is generally intended to convey that certain implementations could include, while other implementations do not include, certain features, elements, and/or operations. Thus, such conditional language is not generally intended to imply that features, elements, and/or operations are in any way required for one or more implementations or that one or more implementations necessarily include logic for deciding, with or without user input or prompting, whether these features, elements, and/or operations are included or are to be performed in any particular implementation.

Many modifications and other implementations of the disclosure set forth herein will be apparent having the benefit of the teachings presented in the foregoing descriptions and the associated drawings. Therefore, it is to be understood that the disclosure is not to be limited to the specific implementations disclosed and that modifications and other implementations are intended to be included within the scope of the appended claims. Although specific terms are employed herein, they are used in a generic and descriptive sense only and not for purposes of limitation.

## Claims

1. A system, comprising:
a tester device for fault isolation on a region of interest (ROI);
an ultraviolet (UV) laser configured to pulse a UV beam targeting the ROI;
a detector configured to capture excited electrons as signals based on the UV beam targeting the ROI; and
a time-domain electrical signal analyzer synchronized to a reference frequency, wherein the time-domain electrical signal analyzer causes a generation of a rastered image associated with the fault isolation.

2. The system of claim 1, wherein the UV laser is a pulsed picosecond UV laser.

3. The system of claim 1 or 2, wherein the integrated circuit comprises a transistor layer that is enclosed between a first metal layer and a second metal layer.

4. The system of any preceding claim, wherein the tester device sends signals through the integrated circuit.

5. The system of any preceding claim, wherein the rastered image is compared to a reference image of a similar region of the integrated circuit.

6. The system of any preceding claim, wherein the UV beam passes through an electron photoemitting microscope having a predetermined UV objective lens.

7. The system of any preceding claim, wherein the rastered image is generated by mapping pixels associated with the signals onto an optical image.

8. The system of claim 7, wherein the pixels are associated with a metal signal line that toggles at the reference frequency.

9. The system of any preceding claim, wherein the reference frequency is based on a tester frequency, a device under test (DUT) frequency, or a pulsed UV beam frequency.

10. A method comprising:
attaching a device under test (DUT) comprising a region of interest (ROI) for fault isolation to a tester device, wherein the DUT is an integrated circuit;
pulsing an ultraviolet (UV) beam targeting the ROI on the DUT using a UV laser;
capturing, using a detector, excited electrons as signals based on the UV beam targeting the ROI;
synchronizing a time domain electrical signal analyzer to a reference frequency; and
generating a rastered image associated with the fault isolation.

11. The method of claim 10, wherein the UV laser is a pulsed picosecond UV laser.

12. The method of claim 10 or 11, wherein the integrated circuit comprises a transistor layer that is enclosed between a first metal layer and a second metal layer.

13. The method of any of claims 10 to 12, wherein the tester device sends signals through the integrated circuit.

14. An apparatus comprising:
a device under test (DUT) comprising a region of interest (ROI) for fault isolation, wherein the DUT is an integrated circuit;
a tester device for fault isolation on a region of interest (ROI);
an ultraviolet (UV) laser configured to pulse a UV beam targeting the ROI;
a detector configured to capture excited electrons as signals based on the UV beam targeting the ROI; and
a time-domain electrical signal analyzer synchronized to a reference frequency, wherein the time-domain electrical signal analyzer causes a generation of a rastered image associated with the fault isolation.

15. The apparatus of claim 14, wherein the UV laser is a picosecond UV laser.
